# EUROPEAN PATENT SPECIFICATION

(11) **EP 2 591 500 B1**
(45) Date of publication and mention of the grant of the patent: **30.09.2015**
(21) Application number: 10749927.9
(22) Date of filing: 07.07.2010
(51) Int. Cl.: H01L 23/473, F28F 21/00

(54) **CMOS COMPATIBLE MICROCHANNEL HEAT SINK FOR COOLING ELECTRONIC COMPONENTS AND ITS FABRICATION**
CMOS-KOMPATIBLER MIKROKANAL-KÜHLKÖRPER ZUR KÜHLUNG ELEKTRONISCHER BAUTEILE SOWIE DESSEN HERSTELLUNG
PUIT THERMIQUE POUR DES MICRO-CANAUX COMPATIBLE AVEC LES CMOS POUR LE REFROIDISSEMENT DE COMPOSANTS ÉLECTRONIQUES ET SA FABRICATION

(43) Date of publication of application: 15.05.2013
(73) Proprietor: Kulah, Haluk, 06531 Ankara (TR); Koyuncuoglu, Aziz, 06531 Ankara (TR); Ozyurt Okutucu, Tuba, 06531 Ankara (TR)
(72) Inventor: Kulah, Haluk, 06531 Ankara (TR); Koyuncuoglu, Aziz, 06531 Ankara (TR); Ozyurt Okutucu, Tuba, 06531 Ankara (TR)
(74) Representative: Karaahmet, Erdogan
(86) International application number: PCT/TR2010/000142
(87) International publication number: WO 2012/005706

(56) References cited:
- EP-A2- 1 796 165
- US-B1- 6 919 231
- DATABASE INSPEC [Online] THE INSTITUTION OF ELECTRICAL ENGINEERS, STEVENAGE, GB; November 2008 (2008-11), YOUNGCHEOL JOO ET AL: "Air cooling of a microelectronic chip with diverging metal microchannels monolithically processed using a single mask", XP002622327, Database accession no. 10308693 -& JOURNAL OF MICROMECHANICS AND MICROENGINEERING IOP PUBLISHING LTD. UK, vol. 18, no. 11, November 2008 (2008-11), XP002622328, ISSN: 0960-1317, DOI: DOI:10.1088/0960-1317/18/11/115022
- DATABASE INSPEC [Online] THE INSTITUTION OF ELECTRICAL ENGINEERS, STEVENAGE, GB; February 2006 (2006-02), DANG B ET AL: "Integrated thermal-fluidic I/O interconnects for an on-chip microchannel heat sink", XP002622329, Database accession no. 8840706 -& IEEE ELECTRON DEVICE LETTERS IEEE USA, vol. 27, no. 2, February 2006 (2006-02), pages 117-119, XP002622330, ISSN: 0741-3106, DOI: DOI:10.1109/LED.2005.862693
- DATABASE INSPEC [Online] THE INSTITUTION OF ELECTRICAL ENGINEERS, STEVENAGE, GB; 1997, PAPAUTSKY I ET AL: "A low temperature IC compatible process for fabricating surface micromachined metallic microchannels", XP002622331, Database accession no. 5651101 -& PROCEEDINGS IEEE THE TENTH ANNUAL INTERNATIONAL WORKSHOP ON MICRO ELECTRO MECHANICAL SYSTEMS. AN INVESTIGATION OF MICRO STRUCTURES, SENSORS, ACTUATORS, MACHINES AND ROBOTS 26-30 JAN. 1997 NAGOYA, JAPAN, 1997, pages 317-322, XP002622332, DOI: DOI:10.1109/MEMSYS.1997.581842 ISBN: 0-7803-3744-1
- KING C R ET AL: "3D stacking of chips with electrical and microfluidic I/O interconnects", ELECTRONIC COMPONENTS AND TECHNOLOGY CONFERENCE, 2008. ECTC 2008. 58TH, IEEE, PISCATAWAY, NJ, USA, 27 May 2008 (2008-05-27), pages 1-7, XP031276161, ISBN: 978-1-4244-2230-2

## Description

### Technical Field of Invention

The present invention is a microchannel heat sink for electronic cooling applications. The heat sink is fabricated using CMOS compatible materials and surface micromachining techniques.

### Background of Innovation

With the advances in microelectronics technology, it is now possible to fit high performance, high speed analog and digital circuits of varying purpose into very small volumes. In contemporary integrated circuits (IC), millions of transistors can be fitted into an area of 1 mm², hence, faster and more functional chips may be produced. On the other hand high density integrated circuits require more power. Therefore, considerable amount of heat is generated in compact volumes and its removal from the system becomes a major design problem. The increase in local temperatures may cause decreased performance or significant damages to the circuits unless the generated heat is removed timely.

Current commercial cooling methods for electronic applications are basic natural and forced air cooling, liquid cooling systems and some refrigeration based systems. The most widely used method is forced convection air cooling, but heat transfer capacity of air cooling is limited about heat flux values of 60 W/cm² and modern CPUs are rapidly approaching this limit [1]. Moreover, hot spots on the CPU die cause even higher heat fluxes, about 3 to 8 times more of the average heat flux of the die, at local points on the chip surface [2]. Liquid cooling systems and refrigeration solutions can cope with heat fluxes up to 100 W/cm², but those systems are bulkier and more complex compared with air cooling systems, increasing the overall cost and causing reliability problems [3]. The use of nanofluids, suspensions of nanoparticles in base fluids, as the working fluid yields an enhancement in heat transfer of more than 50% [4] compared to the use of the base fluid only.

In order to remove higher heat fluxes from the electronic chip surfaces, several new techniques have been introduced. Among them microchannel heat sinks have attracted significant attention for the last three decades [5]. Microchannel heat sinks are basically very compact heat exchangers with enormous area to volume ratios. This ratio provides a very large heat transfer area over the chip surface therefore the heat removal rates of those heat exchangers are much higher than their macro scale versions. Moreover, the small hydraulic diameters of microchannels provide higher heat transfer coefficients, increasing the heat removal rate even further. There are various fabrication methods for manufacturing microchannel heat sinks such as, micromilling [6], laser ablation [7], silicon etching [7, 8, 9, 10], or metal electroplating [11, 12, 13].

Micromilling process requires thick metal substrates and the heat sink is manufactured separately from the microchip [6]. Both factors increase the overall thermal resistance of the cooling system. Similarly, laser ablated microchannels require a separate top cover to form the microchannels [7]. In monolithic designs the heat sink is manufactured along with the circuit by using microfabrication techniques such as silicon etching and electroplating. This provides lower thermal resistance since the junction-to-fluid distance is much shorter compared to that in separate heat sinks. However silicon etching processes have some drawbacks such as the difficulty of back side etching of finished CMOS wafers which may cause reduced fabrication yield [9, 14], or the need for a design change of the circuit to create area for coolant inlet and outlets [8]. On the other hand, electroplated channels can be fabricated directly on top of the circuits without a need for a design change of the underneath circuitry.

Joo et al. investigated electroplated metal microchannels for electronic cooling applications [11]. Their electroplated, radially diverging microchannel heat sinks were able to extract 35 W/cm² with air as the coolant. In this heat sink the top of the channels were covered with the electroplated overhangs extended from the sidewalls, therefore the largest channel width was limited to fewer than 50 microns. On the other hand, the channel height was defined by sacrificial layer thickness which is 70 microns at most. Microchannels with such small dimensions and hydraulic diameters cause enormous pressure drop when used with liquid coolants, therefore the working fluid should be a gas such as air. Since heat transfer coefficient in air cooling is quite low compared to liquid cooling, the maximum heat removal capacity of those microchannel heat sinks were expected to be limited less than 50 W/cm². Using a similar process, Papautsky et al fabricated thin walled metal microchannels electroplated around a sacrificial photoresist layer [12]. These microchannels were used for fluid transfer in chemical processes instead of cooling applications. Another similar document also uses electroplating to form microchannels [13] but high temperature reflow of the electroplated metal makes the fabrication flow not compatible with CMOS circuits.

In order to produce a CMOS compatible surface micromachined microchannel heat sink, the present invention makes use of a polymer top wall instead of electroplated overhangs for covering the microchannels. This design enables fabrication of microchannels that are several hundred microns wide. Therefore higher hydraulic diameter microchannels can be fabricated as well as smaller ones. Besides polymer coating is a simple and CMOS compatible low temperature process. Vapor deposition coating of polymer does not require high temperature curing as used in previous studies [9]. Based on the available pumping power and cooling requirements of the electronic chips, the proposed metal-polymer microchannel heat sinks can be used with various coolants, including gaseous fluids like air, refrigerant, liquid coolants like water, ethylene glycol, or liquid-solid suspensions like nanofluids. With this flexibility, it is possible to obtain much higher heat removal rates from the chip surface.

### The Aims of the Invention

With the proposed invention of CMOS compatible surface micromachined metal-polymer microchannel heat sink, it is aimed to obtain a high heat transfer capacity, light weight, monolithic heat sink structure which can be fabricated easily with standard CMOS compatible surface micromachining techniques and can be operated with gaseous or liquid coolants, or nanofluids.

Compared with the current commercial cooling technologies, the advantages of the proposed device can be summarized as;
- High area to volume ratio of microchannels increases the overall heat transfer capacity of the heat sink.
- The microchannels can be fabricated on the same wafer as the chip itself.
- Fabrication on the same wafer decreases the distance between heated chip surface and coolant medium, decreasing the thermal resistances in the cooling system significantly.
- Using high performance microchannels in the heat sink enables very compact cooling solutions which can be utilized in mobile computer systems as well.

Such advantages are common to most of the microchannel heat sink devices studied in the literature before. In addition to these, the proposed invention adds further advantages to similar microchannel heat sink designs, such as;
- The microchannels can be fabricated directly on top of the heated chip surface by using CMOS compatible surface micromachining techniques, instead of silicon etching processes.
- Since the heat sink can be fabricated directly on the chip surface a monolithic cooling system is obtained.
- No design change required on the chip since the microchannels are fabricated over the chip surface with post-CMOS surface micromachining techniques.
- Microchannels with different cross sections and hydraulic diameters can be fabricated, thus enabling usage of liquids and nanofluids as well as gases as coolants, with acceptable pumping power requirements.

### Descriptions of Figures

Several figures of the different parts of the polymer microchannel heat sink assembly are given in the appendix to provide easy understanding. Brief descriptions of the figures are as follows;
- Figure. 1: Perspective view of microchannels on top of electronic chip with microchannel walls exposed.

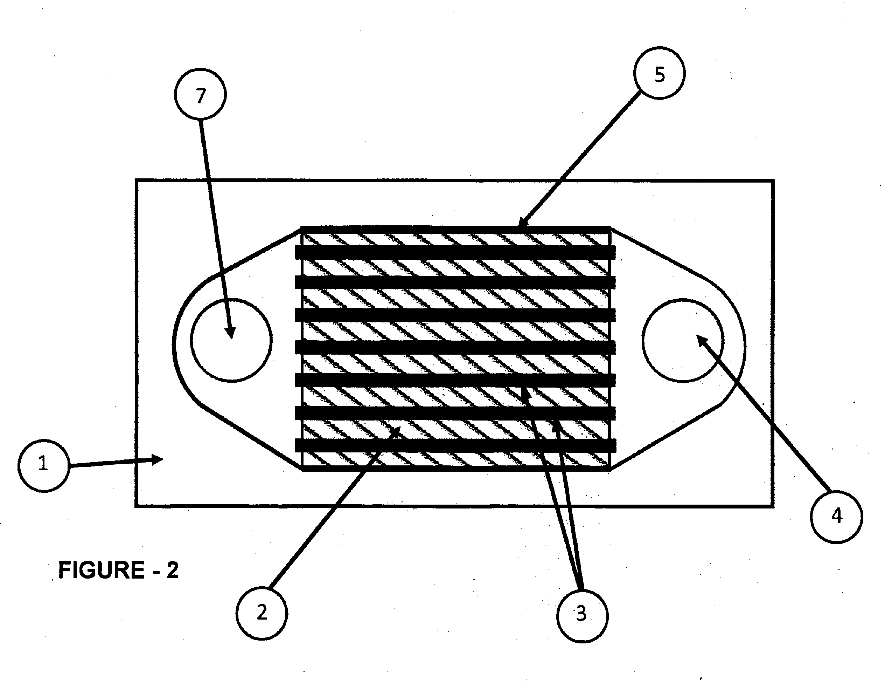

- Figure.2: Top view of microchannel heat sink with polymer top wall removed.

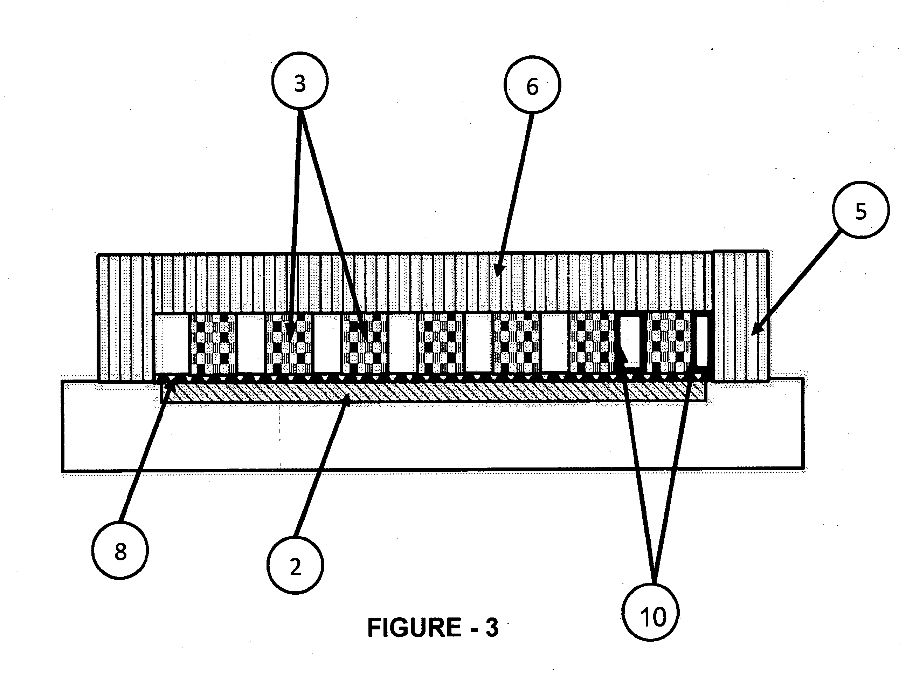

- Figure.3: Cross sectional view of the microchannels along flow direction.
- Figure.4: Fabrication flow of microchannel heat sink.

### Description of the Parts

Composing parts of the polymer microchannel heat sink are shown in the figures by numbers and the respective names are provided below.
1- Silicon wafer under the microelectronic circuit.
2- Microelectronic circuit with electrical insulation layer.
3- Microchannel side walls.
4- Inlet reservoir.
5- Outer walls of microchannel heat sink.
6- Polymer top wall.
7- Outlet reservoir.
8- Metal seed layer.
9- Photoresist Layer
10- Thin Polymer Layers

### Detailed Description of the Invention

The present invention is composed of mainly four elements namely;
- Metal seed layer (8) on top of the microelectronic circuit with electrical insulation layer (2),
- Parallel microchannels with metal side walls (3),
- Polymer top wall (6),
- Inlet (4)-outlet (7) reservoirs.

The electrical insulation layer is deposited on the microelectronic circuit with electrical insulation layer (2) by means of standard vapor deposition techniques, in order to prevent any electrical interaction between the electronic chip and the coolant. The insulation layer can be made of either silicon dioxide, silicon nitride or a polymer film. Microchannels lay on top of the metal seed layer (8) which is deposited over the insulation layer. Microchannels are formed by metal seed layer (8) at the bottom wall and electroplated metal (e.g. Copper, Nickel or Gold) on the microchannel side walls (3) and polymer top wall (6). Thin polymer layers can be coated on inner surface of the microchannels, including the metal surface on the microchannel side walls (3), metal seed layer (8) and polymer top wall (6) as the final step in the fabrication process to prevent corrosion due to contact of coolant and metal.

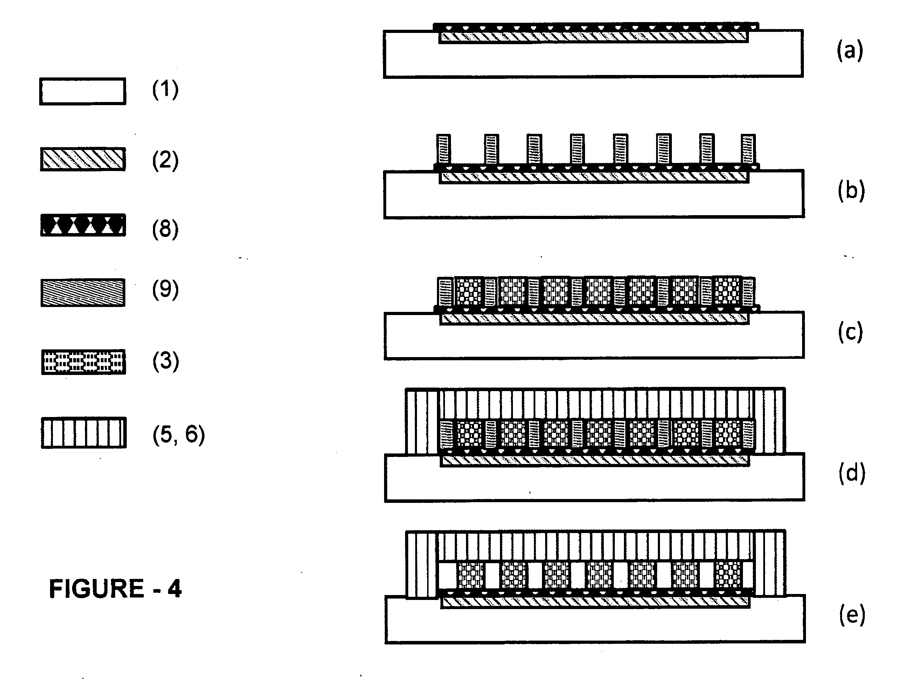

Fabrication method of the microchannel heat sink is shown in Figure 4 schematically. Fabrication is a two-mask process. Microchannel heat sink is fabricated directly on top of the microelectronic circuit with electrical insulation layer (2). First a thin metal seed layer is coated on top of the insulation layer for electroplating process (Figure 4-a). Seed layer is patterned by using Mask-1 with UV-lithography and wet metal etching, in order to prevent electroplating on top of contact pads of the underneath circuitry. By using Mask-2 a sacrificial thick photoresist layer is patterned, forming the microchannels and inlet-outlet reservoirs (Figure 4-b). Microchannel dimensions are defined by Mask-2 layout and photoresist thickness. Then metal is electroplated between the sacrificial photoresist lines (Figure 4-c). A thick polymer layer is then coated forming the polymer top wall (6) (Figure 4-d). This layer provides both visibility and easy sealing. Next, the inlet and outlet connection ports and contact pads are opened in O₂ plasma with a thick photoresist layer patterned by again Mask-1, protecting the polymer top wall over microchannels. Finally, the sacrificial photoresist is removed by acetone-I PA-methanol release (Figure 4-e).

By using different photoresists, various microchannel thicknesses can be obtained. Moreover, employing the polymer top wall (6), not only narrow microchannels, but also larger channels, as wide as several hundred microns can be fabricated. As a result of dimension flexibility, different working fluids (gas, liquid, nanofluid) can be used as coolants with acceptable pressure drops.

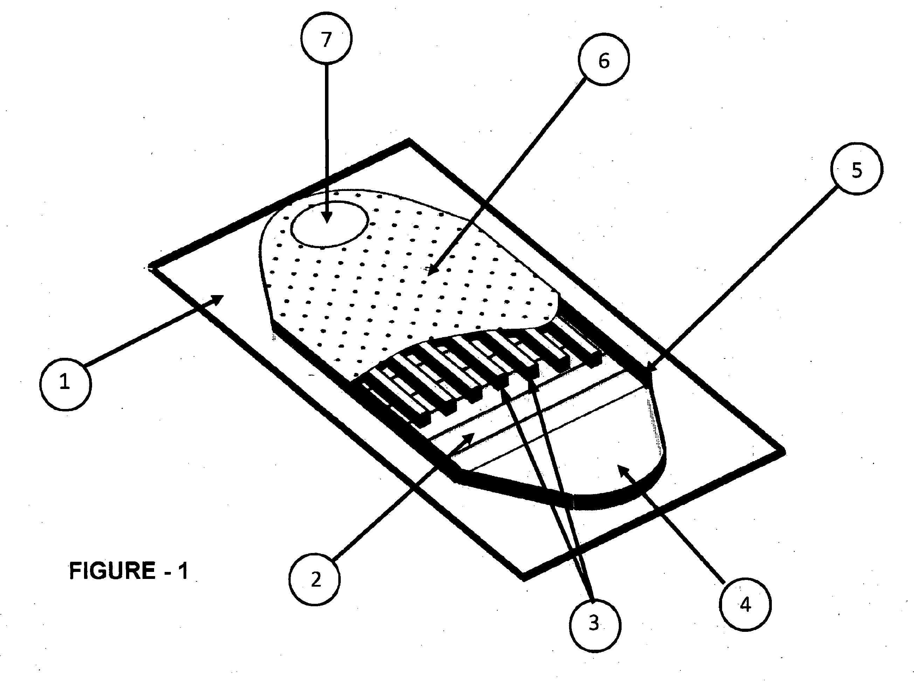

The overall electronic cooling system is composed of the metal - polymer microchannel heat sink (Fig. 1), inlet and outlet microfluidic interconnection ports (not shown), piping (not shown), pump/compressor (not shown) and external heat exchanger (not shown). Parts other than the microchannel heat sink are standard cooling system components which are already commercially available.

### Operation of the System

The metal-polymer microchannel heat sink provides cooling by means of steady state flow of a working fluid inside the microchannels. The working fluid can be either water or some other coolant, based on the operation conditions and cooling requirements of the chip. The working fluid is pumped in the closed loop cooling system by a pump. Then the fluid flows through the pipes and reaches the inlet reservoir (4) of the polymer microchannel heat sink. In the inlet reservoir the working fluid is distributed to microchannels and flows through microchannels. During the flow the working fluid is heated by the heat flux coming from the microelectronic circuit with electrical insulation layer (2) under the metal seed layer (8). The temperature of the working fluid increases while flowing down the microchannels. The hot working fluid is collected in the outlet reservoir (7) of the heat sink and leaves the microchannel heat sink through the microfluidic interconnection ports.

The hot working fluid then flows through pipes and radiator (not shown) where it is cooled by ambient air by means of natural or forced convection. The cooled down working fluid flows thorough pipes and reaches pump (not shown) completing the one cooling cycle.

### References

[1] Wei, Jie (2008) Challenges in Cooling Design of CPU Packages for High-Performance Servers, Heat Transfer Engineering, 29: 2, 178-187
[2] Mahajan R., (2006), Cooling a Microprocessor Chip, Proceedings of the IEEE, 94: 8.
[3] Kandlikar S. G., Grande W., (2004), Evaluation of Single Phase Flow in Microchannels for High Heat Flux Chip Cooling-Thermohydraulic Performance Enhancement and Fabrication Technology, Heat Transfer Engineering, 25: 8, 5-16
[4] L. Godson, B. Raja, D. Mohan Lal, and S. Wongwises, "Enhancement of heat transfer using nanofluid - An overview", Renewable and Sustainable Energy Reviews 14 (2010) 629-641.
[5] D. B. Tuckerman, R. F. W. Pease. *"Method and means for improved heat removal in compact semiconductor integrated circuits and similar devices utilizing coolant chambers and microscopic channels"* U.S. Patent 4 450 472, May 22, 1984
[6] P.S. Lee, S.V. Garimella, and D. Liu, Investigation of heat transfer in rectangular microchannels, International Journal of Heat and Mass Transfer, vol. 48, 2005, pp. 1688-1704.
[7] Durocher Kevin Matthew, "Method Of Making An Electronic Device Cooling System", EP 1796165 A2, 13 June 2007
[8] G. Kaltsas, D.N. Pagonis, and A.G. Nassiopoulou, Planar CMOS compatible process for the fabrication of buried microchannels in silicon, using porous-silicon technology, Journal of Microelectromechanical Systems, vol. 12, 2003, pp. 863-872
[9] B. Dang, M. S. Bakir, and J. D. Meindl, "Integrated thermal-fluidic I/O interconnects for an on-chip microchannel heat sink," Electron Device Letters, IEEE, vol. 27, no. 2, pp. 117-119, Feb. 2006.
[10] C.R. King, D. Sekar, M.S. Bakir, B. Dang, J. Pikarsky, J.D. Meindl, "3D stacking of chips with electrical and microfluidic I/O interconnects," Electronic Components and Technology Conference, 2008. ECTC2008. 58th , vol., no., pap. 1-7, 27-30 May
[11] Y. Joo, H.C. Yeh, K. Dieu, and C.J. Kim, Air cooling of a microelectronic chip, Journal of Micromechanics and Microengineering, vol. 18, 2008, p. 115022
[12] I. Papautsky; A.B. Frazier, H. Sliverdlow, "A low temperature IC compatible process for fabricating surface micromachined metallic microchannels," Micro Electro Mechanical Systems, 1997. MEMS '97, Proceedings, IEEE., Tenth Annual International Workshop on, vol., no., pp.317-322, 26-30 Jan 1997
[13] S. Ramanathan, C. C. Cheng, and A. M. Myers, "Methods of forming channels on an integrated circuit die and die cooling ...," U.S. Patent 6919231 19-Jul-2005.
[14] R. J. Bezama, E. G. Colgan, J. H. Magerlein, R. R. Schmidt. *"Apparatus and methods for microchannel cooling of semiconductor integrated circuit packages"* U.S. Patent 7 139 172, Nov 21, 2006

## Claims

1. A fabrication technique of microchannel heat sink for electronic cooling applications with liquid, nanofluid and gas, comprising the steps of, electroplating the microchannel side walls (3) between the sacrificial photoresist layers (9) on a thin-film metal seed layer (8) on top of the microelectronic circuit with electrical insulation layer (2), removing the sacrificial photoresist layers (9) by acetone-IPA-methanol release and **characterized in that**, sacrificial photoresist layer (9) and microchannel side walls (3) are covered with a polymer top wall (6), before the sacrificial photoresist layers (9) are removed by acetone-IPA-methanol release.

2. A fabrication technique of microchannel heat sink for electronic cooling applications with liquid, nanofluid, and gas as claimed in claim 1 and **characterized in that**, thin polymer layers (10) are coated on the inner surface of the microchannels, including the metal surface on the microchannel side walls (3), metal seed layer (8) and polymer top wall (6), after the sacrificial photoresist layers (9) are removed by acetone-IPA-methanol release.

3. A microchannel heat sink for electronic cooling applications with liquid, nanofluid and gas, **characterized in that**, it is fabricated according to claim 1.

4. A microchannel heat sink for electronic cooling applications with liquid, nanofluid and gas, **characterized in that**, it is fabricated according to claim 2.

5. A microchannel heat sink for electronic cooling applications with liquid, nanofluid and gas, as claimed in claims 3 and 4, and **characterized in that**, cooling is supplied by circulation of the fluid through microchannels with inlet and outlet microfluidic connection ports.

## Patentansprüche

1. Herstellungstechnik eines Kühlkörpers mit Mikrokanälen für elektrische Kühlungsanwendungen durch Flüssigkeiten, Nanoflüssigkeiten und Gasen bestehend aus Verfahrensschritten, Galvanisieren der Seitenwänden (3) zwischen den entbehrlichen photobeständigen Schutzschichten (9) auf einer Dünnfilmmetalkeimschicht (8) auf der Oberseite der mikroelektronischen Schaltung mittels einer elektrischen Isolationschicht (2), Entfernen der entbehrlichen photobeständigen Schutzschichten (9) durch Evakuiren von Aceton-IPA-Methanol **dadurch gezeichnet daβ,** die entbehrlichen photobeständigen Schutzschichten (9) und Mikrokanäleseitenwänden (3) bevor dem Entfernen der entbehrlichen photobeständigen Schutzschichten (9) durch Evakuiren von Aceton-IPA-Methanol mit einer polimerischen Oberflächenschicht (6) beschichtet sind.

2. Herstellungstechnik eines Kühlkörpers mit Mikrokanäleseitenwänden (3) für elektrische Kühlungsanwendungen durch Flüssigkeiten, Nanoflüssigkeiten nach Anspruch 1, **dadurch gezeichnet daβ,** die polimerischen dünnen Schichten (10) in der Innenfläche der Mikrokanälen, einschließlich der metallischen Oberflächen an den Mikrokanäleseitenwänden (3), der Metalkeimschicht (8) und der polimerische Oberflächenschicht (6) nach dem Entfernen der entbehrlichen photobeständigen Schutzschichten (9) durch Evakuiren von Aceton-IPA-Methanol, beschichtet sind.

3. Ein Kühlkörper mit Mikrokanäleseitenwänden (3) für elektrische Kühlungsanwendungen durch Flüssigkeiten, Nanoflüssigkeiten, **dadurch gezeichnet daβ,** er gemäß der Anspruch 1 hergestellt ist.

4. Ein Kühlkörper mit Mikrokanäleseitenwänden (3) für elektrische Kühlungsanwendungen durch Flüssigkeiten, Nanoflüssigkeiten, **dadurch gezeichnet daβ,** er gemäß der Anspruch 2 hergestellt ist.

5. Ein Kühlkörper mit Mikrokanäleseitenwänden (3) für elektrische Kühlungsanwendungen durch Flüssigkeiten, Nanoflüssigkeiten nach Ansprüchen 3 und 4 **dadurch gezeichnet daβ,** die Kühlung durch den Kreislauf der Flüssigkeit mittels der mikrofluidischen Mikrokanälen mit Ein-, und Auslaßöffnungen zugeführt wird.

## Revendications

1. Une technique de fabrication du puits thermique micro-canaux pour les applications de refroidissement électronique avec du fluide, nano-fluide, et du gaz, comportant les étapes de l'électrodéposition des flancs micro-canaux (3) entre les couches photorésistantes sacrificielles (9) sur une mince couche germinale métallique (8) au-dessus du circuit micro-électronique avec une couche d'isolation électrique (2), l'enlèvement des couches photorésistantes sacrificielles (9) par la libération de l'acétone-IPA-méthanol et **caractérisé en ce que** la couche photorésistante sacrificielle (9) et les flancs micro-canaux (3) sont recouverts d'une paroi supérieure en polymère (6) avant que les couches photorésistantes sacrificielles (9) sont éliminées par la libération de l'acétone-IPA-méthanol.

2. Une technique de fabrication du puits thermique micro-canaux pour les applications de refroidissement électronique avec du fluide, nano-fluide, et du gaz comme revendiqué à la revendication 1 et **caractérisée en ce que** les couches en polymère (10) sont recouvertes d'une surface intérieure des micro-canaux, y compris la surface métallique sur les flancs micro-canaux (3), la couche germinale métallique (8), et la paroi supérieure en polymère (6), après que les couches photorésistantes sacrificielles (9) soient éliminés par la libération de l'acétone-IPA-méthanol.

3. Un puits thermique micro-canaux pour les applications de refroidissement électronique avec du fluide, nano-fluide, et du gaz, **caractérisé en ce qu'**il est fabriqué selon la revendication 1.

4. Un puits thermique micro-canaux pour les applications de refroidissement électronique avec du fluide, nano-fluide, et du gaz, **caractérisé en ce qu'**il est fabriqué selon la revendication 2.

5. Une technique de fabrication du puits thermique micro-canaux pour les applications de refroidissement électronique avec du fluide, nano-fluide, et du gaz comme revendiquée aux revendications 3 et 4 et **caractérisé en ce que** le refroidissement est fournie par la circulation du fluide au moyen des micro-canaux avec les portes de connexion micro-fluide d'entrée et sortie.
